# EUROPEAN PATENT APPLICATION

(11) **EP 4 576 946 A2**
(43) Date of publication of application: **25.06.2025**
(21) Application number: 24221862.6
(22) Date of filing: 19.12.2024
(51) Int. Cl.: H05K 1/02

(54) **GROUNDING OPTIMIZATION FOR UNSHIELDED DATA CONNECTIONS**

(30) Priority: 19.12.2023 US 202363612335 P; 18.12.2024 US 202418985837
(71) Applicant: Marvell Asia Pte Ltd, Singapore 369522 (SG)
(72) Inventor: Huang, Shaowu, Los Altos, CA 94022 (US); Wu, Dance, Palo Alto, CA 94306 (US)
(74) Representative: Grünecker Patent- und Rechtsanwälte PartG mbB

(57) **Abstract**

An unshielded data connection is disposed on a first surface of a printed circuitry board having a major plane. The unshielded data connection is disposed within an imaginary plane, perpendicular to the surface of the printed circuit board, that includes the unshielded data connection as a line segment within the imaginary plane. A symmetrical arrangement of one or more ground connections is disposed around the unshielded data connection. The arrangement is symmetrical with respect to the imaginary plane.

## Description

### Cross Reference to Related Applications

This disclosure claims the benefit of copending, commonly-assigned United States Provisional Patent Application No. 63/612,335, filed December 19, 2023, which is hereby incorporated by reference herein in its entirety.

### Field of Use

This disclosure relates to unshielded data connections in a high interference network, such as an automotive network. More particularly, this disclosure relates to grounding techniques to reduce interference on unshielded data connections.

### Background

The background description provided herein is for the purpose of generally presenting the context of the disclosure. Work of the inventors hereof, to the extent the work is described in this background section, as well as aspects of the description that may not otherwise qualify as prior art at the time of filing, are neither expressly nor impliedly admitted to be prior art against the subject matter of the present disclosure.

In the automotive industry, unshielded twisted pair (UTP) cables are often used for communication with physical layer transceiver (PHY) system-on-a-chip (SoC) devices with speeds up to 1 Gbps. UTP cables are also often implemented for switch SoC devices with integrated PHY ports with speeds up to 1000BT1. Medium dependent interfaces (MDIs) are used to physically connect these devices to UTP cables. MDIs serve as the connection point between devices and the transmission medium, such as copper cables or optical fibers.

An MDI is a physical interface that connects a device to the transmission medium used for data communication, such as copper wires, optical fibers, or wireless channels. The MDI serves as the critical boundary where the electrical or optical signals generated by the device are adapted for propagation through the chosen transmission medium. MDIs are integral components of communication systems and are typically designed to comply with established standards, such as IEEE 802.3 for Ethernet, ensuring compatibility and interoperability between different devices.

MDIs are defined by their physical connectors, electrical or optical signaling specifications, and impedance matching capabilities. MDIs are often equipped with mechanisms to handle medium-specific challenges, such as electromagnetic interference in copper-based systems or modal dispersion in optical fiber systems. In addition to signal transmission, MDIs may incorporate features for signal conditioning, such as amplification, filtering, or equalization, to maintain data integrity over various distances and media types. Depending on the application, MDIs can also include protection circuits, grounding provisions, and isolation mechanisms to safeguard devices from transient voltages, surges, or ground loops. These interfaces play a pivotal role in enabling reliable and efficient data transfer in both wired and wireless communication systems.

Grounding for MDIs, particularly in network systems such as Ethernet, is crucial for maintaining performance, reliability, and safety. Proper grounding ensures that electrical interference and signal integrity issues are minimized.

MDI grounding connection schemes have significant impacts on the electromagnetic interference performance of automotive networks with UTP cable channels. Unshielded cable channels (i.e., UTP cables) have a different behavior in grounding relative to shielded cables and need to be carefully optimized. MDI grounding can have a negative impact on UTP cables if not implemented correctly. The interaction between MDI grounding and UTP cables affects the susceptibility of the UTP cable to noise. Improper grounding at the MDI can introduce common-mode noise into the UTP cable. Since UTP cables lack shielding, they are more vulnerable to noise if the grounding is not properly managed. This noise can degrade the differential signals transmitted through the twisted pairs, leading to errors or reduced data rates.

MDI grounding can also affect ground loops. Ground loops occur when there are differences in ground potential between interconnected devices, creating a loop where unintended current flows. With UTP cables, ground loops can induce interference into the signal, as the cable does not have a shield to isolate the twisted pairs from external electrical disturbances.

### Summary

Systems and methods are described herein for providing grounding optimization for unshielded data connections in an automotive network. The unshielded data connection may be a differential signal trace pair disposed on a first surface of a printed circuitry board (PCB), the PCB having a major plane. The differential signal trace pair is disposed within an imaginary plane, perpendicular to the surface of the PCB, that includes the differential signal trace pair as a line segment within the imaginary plane. A symmetrical arrangement of one or more ground connections is disposed around the differential signal trace pair. The arrangement is symmetrical with respect to the imaginary plane.

For an even number of ground connections, a first half of the ground connections may be disposed to one side of the imaginary plane while a second half of the ground connections may be disposed to the other side of the imaginary plane. For an odd number of ground connections, a first half of the ground connections of an even-numbered subset of the odd number of ground connections may be disposed on a first surface of the PCB to one side of the imaginary plane while a second half of the ground connections of the even-numbered subset are disposed on the first surface of the PCB to the other side of the imaginary plane. Of a remaining number of ground connections, a first ground connection is disposed on a second surface of the PCB at a location that intersects the imaginary plane. The rest of the remaining number of ground connections, being an even number of ground connections, are disposed on the second surface of the PCB, distributed symmetrically with respect to the imaginary plane.

In some implementations, the PCB is a multi-layer PCB. A single ground connection may be disposed on an interior layer of the PCB at a location that intersects the imaginary plane. An even number of ground connections may be disposed on the interior layer of the PCB, distributed symmetrically with respect to the imaginary plane. An odd number of ground connections may be disposed on the interior layer of the PCB with a first ground connection disposed at a location that intersects the imaginary plane and the remaining even number of ground connections distributed symmetrically with respect to the imaginary plane.

The ground connection may be a solid ground plane, one or more metallic strips, one or more zero-ohm resistors, or one or more capacitors. In each of these implementations, the ground connections are distributed symmetrically with respect to the imaginary plane.

### Brief Description of the Drawings

Further features of the disclosure, its nature and various advantages, will be apparent upon consideration of the following detailed description, taken in conjunction with the accompanying drawings, in which like reference characters refer to like parts throughout, and in which:
FIG. 1 is an illustrative diagram of an MDI connection with a symmetrical arrangement of ground connections for a number of differential signal trace pairs, in accordance with some implementations of the subject matter of this disclosure;
FIG. 2 is an illustrative diagram of an MDI connection with a second symmetrical arrangement of ground connections for a number of differential signal trace pairs, in accordance with some implementations of the subject matter of this disclosure;
FIG. 3 is an illustrative diagram of an MDI connection with a symmetrical arrangement of ground connections for a number of differential signal trace pairs and an additional asymmetrical ground connection, in accordance with some implementations of the subject matter of this disclosure;
FIG. 4 is an illustrative diagram of an MDI connection with different symmetrical arrangements of ground connections for different differential signal trace pairs, in accordance with some implementations of the subject matter of this disclosure;
FIG. 5 is an illustrative diagram of an MDI connection with a symmetrical arrangement of ground connections for a number of different signal trace pairs from different signal sources, in accordance with some implementations of the subject matter of this disclosure;
FIG. 6 is an illustrative diagram of a symmetrical arrangement of an odd number of ground connections disposed on different surfaces of a printed circuit board, in accordance with some implementations of the subject matter of this disclosure;
FIG. 7 is an illustrative diagram of a symmetrical arrangement of an even number of ground connections disposed on different surfaces of a printed circuit board, in accordance with some implementations of the subject matter of this disclosure;
FIG. 8 is an illustrative diagram of a second symmetrical arrangement of an odd number of ground connections disposed on different surfaces of a printed circuit board, in accordance with some implementations of the subject matter of this disclosure;
FIG. 9 is an illustrative diagram of a symmetrical arrangement of an odd number of ground connections disposed on different surfaces and within at least on interior layer of a printed circuit board, in accordance with some implementations of the subject matter of this disclosure; and
FIG. 10 is a flow diagram representing an illustrative process for shielding a differential signal trace pair using a symmetrical arrangement of ground connections, in accordance with some implementations of the subject matter of this disclosure.

### Detailed Description

Currently, very little MDI grounding optimization is performed. Due to the lack of optimization, the current UTP MDI grounding can degrade the performance of the UTP channel with respect to its tolerance to electromagnetic interference and electrostatic discharge. This can cause failures, particularly in switch systems that usually have multiple integrated PHYs.

By providing methods and systems for grounding optimization for unshielded data connections to MDI ports, performance of data connections, with respect to tolerance to electromagnetic interference and electrostatic discharge, is greatly improved, making automotive networks more robust.

A grounding optimization solution is described herein, in which critical grounding is applied symmetrically around each differential signal trace pair that connected to an MDI port. Ground connections are placed close to each differential signal trace pair, though the distance for any given ground connection may depend on the number and specific arrangement of ground connections. For example, an arrangement of 2 ground connections, each ground connection may be placed within 2 mm of the differential signal trace pair. A ground connection in an arrangement of 4 ground connections may be placed further away from the differential signal trace pair, as long as the ground connection can still provide a shielding effect to the differential signal trace pair. The ground connections may be solid plane connections, metallic strips, or zero-ohm resistors. For alternating current grounding schemes, capacitors may also be used.

For solid ground planes, each ground connection is disposed on a PCB at a location that intersects an imaginary plane that is perpendicular to a major plane of the PCB and includes the differential signal trace pair as a line segment within the plane. An uninterrupted, for instance a solid, ground plane may be disposed in an interior layer of a multi-layer PCB, in an implementation. At least a portion of the solid ground plane may be disposed to either side of the imaginary plane, such that there are essentially infinite ground connections to either side of the imaginary plane. Accordingly, such disposition of a solid ground plane is a symmetrical arrangement of ground connections. For other types of ground connections (e.g., zero-ohm resistors), the symmetrical arrangement depends on the number of ground connections used. For a single ground connection, the grounding element (e.g., a zero-ohm resistor) is disposed similarly to a solid ground plane connection, wherein the grounding element is disposed at a location on the PCB that intersects the imaginary plane.

For an even number of ground connections, the grounding elements may be disposed at locations on the PCB in a symmetrical distribution to either side of the imaginary plane. For example, if two grounding elements are used, one grounding element may be disposed on one side of the imaginary plane at a specific distance from the differential signal trace pair (e.g., 1 mm) and a second grounding element may be disposed on the other side of the imaginary plane at the same distance from the differential signal trace pair. In some implementations, the PCB may be a multi-layer PCB. A grounding element (e.g., a metallic strip) may be disposed in an interior layer of the PCB. One or more grounding elements may therefore be disposed in an interior layer of the PCB. For example, if four grounding elements are used, two grounding elements may be disposed to either side of the imaginary plane as described above. A third grounding element may be disposed on an opposite surface of the PCB at a location that intersects the imaginary plane. A fourth grounding element may be disposed in an interior layer of the PCB at a location that intersects the imaginary plane. Other symmetrical arrangements and other numbers of grounding elements are possible, and all are contemplated by this disclosure.

For an odd number of ground connections, at least one ground connections may be disposed at a location that intersects the imaginary plane. A remaining even number of ground connections may then be disposed in a symmetrical arrangement, distributed evenly to either side of the imaginary plane.

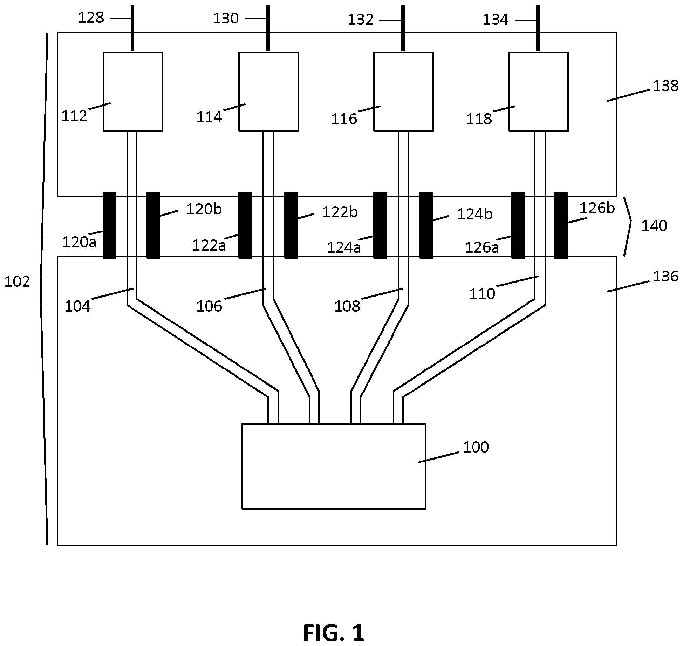

FIG. 1 is an illustrative diagram of an MDI connection with a symmetrical arrangement of ground connections for a number of differential signal trace pairs, in accordance with some implementations of the subject matter of this disclosure. Signal source 100 is disposed on PCB 102. Differential signal trace pairs 104, 106, 108, and 110 transmit signals from signal source 100 to MDI ports 112, 114, 116, and 118, respectively.

Differential signal trace pairs 104, 106, 108, and 110 are unshielded and are subject to electromagnetic interference. Additionally, wires, 128, 130, 132, and 134 are unshielded twisted pairs of a UTP cable which is connected to MDI ports 112, 114, 116, and 118. This UTP cable is further subject to electromagnetic interference. Each differential signal trace pair is protected from at least some electromagnetic interference through the presence of ground connections.

Ground connections serve a critical role in ensuring signal integrity, device protection, and system reliability. Ground connections provide a stable electrical reference point for the transmission and reception of signals, mitigating the effects of electromagnetic interference, reducing noise, and preventing voltage imbalances that could compromise data signal integrity. The use of ground connections also protects connected devices from transient electrostatic discharge, such as from power surges, by safely diverting excess current away from sensitive circuitry. Multi-point grounding schemes are often used in high-frequency systems such as automotive electronics, to reduce impedance. The ground connections may all be connected to a common ground plane or may be connected, via wires or traces, to a common ground (not shown).

For optimal performance, the ground connections are symmetrically arranged around each differential signal trace pair. Ground connections 120a and 120b are disposed to either side of an imaginary plane perpendicular to the surface of PCB 102 and in which differential signal trace pair 104 forms a line segment. Similarly, ground connections 122a and 122b are disposed around differential signal trace pair 106, ground connections 124a and 124b are disposed around differential signal trace pair 108, and ground connections 126a and 126b are disposed around differential signal trace pair 110.

Signal source 100 is disposed in a first area 136 of PCB 102. Area 136 may comprise a first ground plane for digital logic disposed on PCB 102. MDI ports 112, 114,116, and 118 are disposed in a second area 138 of PCB 102. Area 138 may comprise a second ground plane for the cable connection made via the MDI ports. Discontinuity 140 on the surface or in the ground plane layer of PCB 102 is used for electrically isolating between area 136 and area 138. Discontinuity 140 may be formed, for example, by etching or otherwise removing part of a metal layer so as to create a gap between different ground regions.

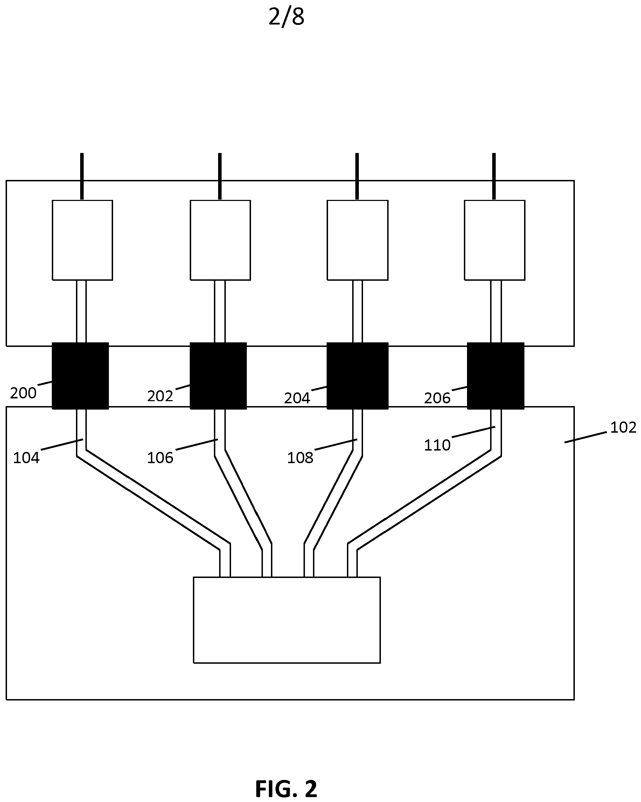

FIG. 2 is an illustrative diagram of an MDI connection with a second symmetrical arrangement of ground connections for a number of differential signal trace pairs, in accordance with some implementations of the subject matter of this disclosure. In this arrangement, ground connections 200, 202, 204, and 206 are disposed to protect differential signal trace pairs 104, 106, 108, and 110, respectively. Ground connections 200, 202, 204, and 208 are solid ground planes. Each of ground connections 200, 202, 204, and 206 are disposed at a location that intersects an imaginary plane perpendicular to the surface of PCB 102 and in which a respective differential signal trace pair forms a line segment. By being disposed in these locations, with half of their width on either side of the imaginary plane, each ground connection is symmetrically distributed with respect to the imaginary plane.

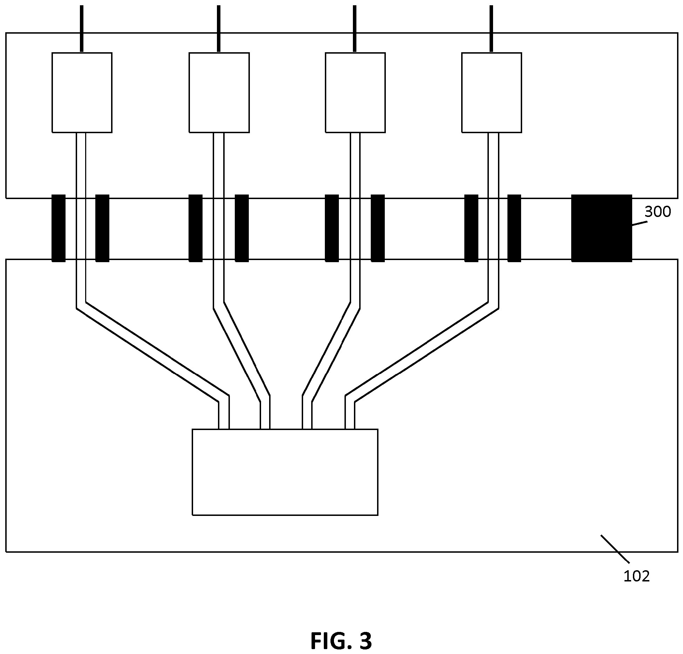

FIG. 3 is an illustrative diagram of an MDI connection with a symmetrical arrangement of ground connections for a number of differential signal trace pairs and an additional asymmetrical ground connection, in accordance with some implementations of the subject matter of this disclosure. In some implementations, PCB may be subject to diverging transient noise currents or electrostatic discharge. To better shield the differential signal trace pairs, at least one additional ground connection 300 may be disposed on PCB 102. Ground connection 300 may be disposed asymmetrically with respect to the differential signal trace pairs. In one example, shown in FIG. 3, a single ground connection 300 is disposed near an edge of PCB 102. Other numbers and locations of ground connections are possible.

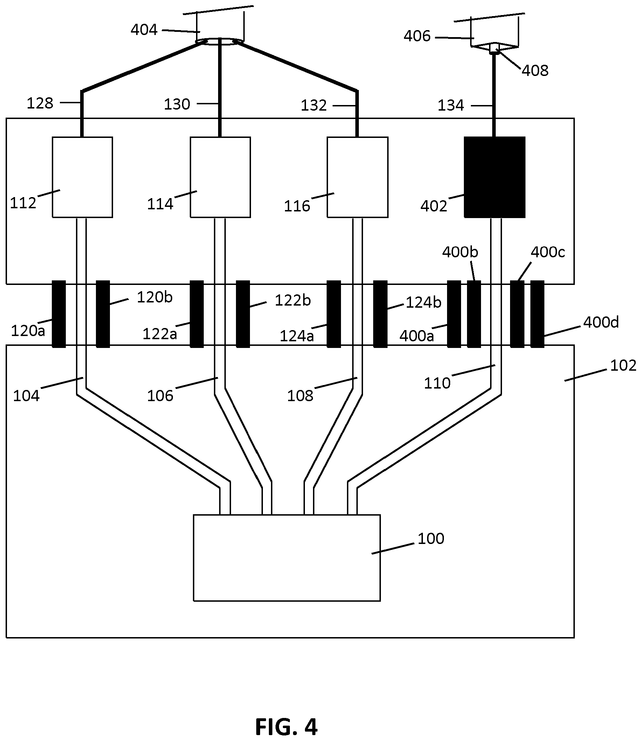

FIG. 4 is an illustrative diagram of an MDI connection with different symmetrical arrangements of ground connections for different differential signal trace pairs, in accordance with some implementations of the subject matter of this disclosure. Signal source 100 is disposed on PCB 102. Differential signal trace pairs 104, 106, 108, and 110 transmit signals from signal source 100 to MDI ports 112, 114, 116, and 118, respectively. Differential signal trace pairs 104, 106, 108, and 110 are unshielded and are subject to electromagnetic interference.

The cable 404, from which wires 128, 130, and 132 are connected to MDI ports 112, 114, and 116, respectively, is an unshielded twisted pair cable and is further subject to electromagnetic interference. However, the cable 406, from which wire 134 is connected to MDI port 402 is a shielded twisted pair cable and is subject to less electromagnetic interference than the unshielded twisted pair cable. For example, wire 134 is shielded by shielding 408 within cable 406. Accordingly, the ground connections used to shield differential signal trace pair 110 may be optimized for a shielded twisted pair cable. In one example, differential signal trace pairs 104, 106, and 108 are shielded using two ground connections 120a-b, 122a-b, and 124a-b, respectively. Differential signal trace pair 110, on the other hand, is shielded by four ground connections 400a-d having electrical properties optimized for a channel using a shielded twisted pair cable. For example, the shielding effectiveness of a STP cable may be 60 dB, meaning it can reduce the interference by a factor of 1,000. The ground connections may be configured to provide sufficient shielding only against interference that might exceed the shielding effectiveness of the STP cable. In contrast, an UTP cable provides no additional shielding beyond that provided by twisting the wire pairs within the cable,
and requires ground connections configured to be effective against greater levels of interference.

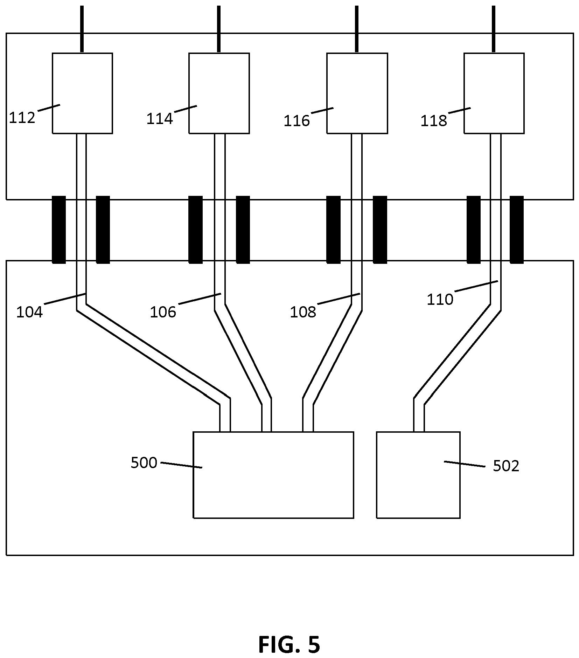

In some implementations, the MDI connection, of which MDI ports 112, 114, 116, and 118 are a part, may carry data from multiple sources. FIG. 5 is an illustrative diagram of an MDI connection with a symmetrical arrangement of ground connections for a number of different signal trace pairs from different signal sources, in accordance with some implementations of the subject matter of this disclosure. In this example, differential signal trace pairs 104, 106, and 108 are connected to a first signal source 500 while differential signal trace pair 110 is connected to a second signal source 502. Even with different signal sources, each differential signal trace pair is still shielded using a symmetrical arrangement of ground connections, as described above.

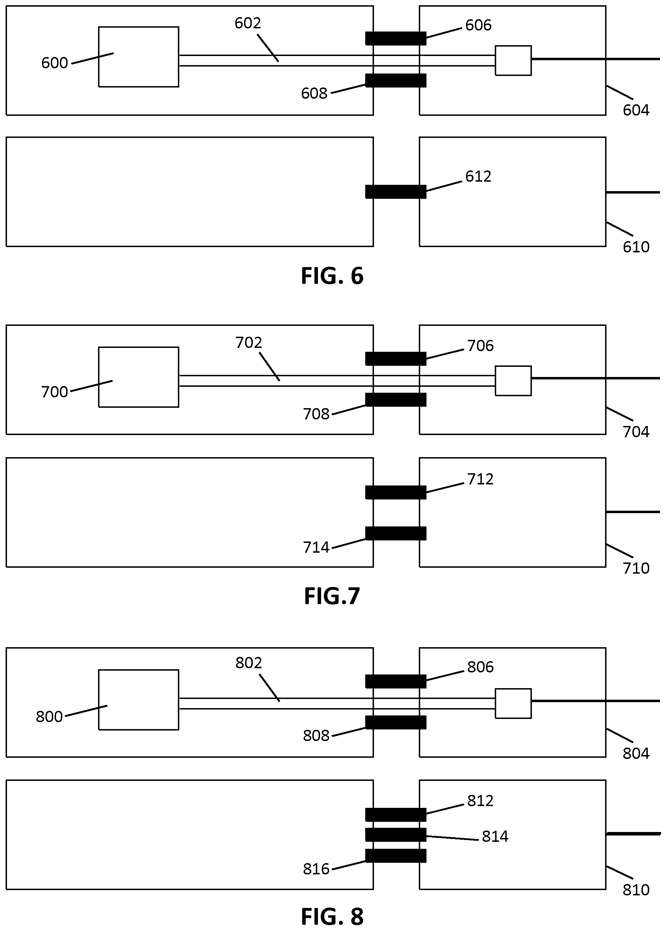

FIGS. 6-8 show different symmetrical arrangements of both even and odd numbers of ground connections for a differential signal trace pair. Different arrangements may be achieved by disposing ground connections on different surfaces of a PCB in a region surrounding the differential signal trace pair. A distance between the differential signal trace pair and a ground connection changes the effective level of shielding provided by the ground connection. Accordingly, the placement of ground connections in a symmetrical arrangement of ground connections can impact the overall effectiveness of the symmetrical arrangement of ground connections.

FIG. 6 is an illustrative diagram of a symmetrical arrangement of an odd number of ground connections disposed on different surfaces of a printed circuit board, in accordance with some implementations of the subject matter of this disclosure. FIG. 6 depicts two opposing surfaces 604 and 610 of a PCB. Signal source 600 and differential signal trace pair 602 are disposed on a first surface 604 of a PCB. Ground connections 606 and 608 are also disposed on surface 604 and arranged symmetrically to either side of an imaginary plane perpendicular to surface 604 that includes differential signal trace pair 602 as a line segment within the imaginary plane. On the opposing surface 610 of the PCB, ground connection 612 is also disposed symmetrically with respect to the imaginary plane, which is to say that the imaginary plane intersects ground connection 612 at its midpoint such that half of ground connection 612 is disposed to either side of the imaginary plane.

FIG. 7 is an illustrative diagram of a symmetrical arrangement of an even number of ground connections disposed on different surfaces of a printed circuit board, in accordance with some implementations of the subject matter of this disclosure. FIG. 7 depicts two opposing surfaces 704 and 710 of a PCB. Signal source 700 and differential signal trace pair 702 are disposed on a first surface 704 of a PCB. Ground connections 706 and 708 are also disposed on surface 704 and arranged symmetrically to either side of an imaginary plane perpendicular to surface 704 that includes differential signal trace pair 702 as a line segment within the imaginary plane. On the opposing surface 710 of the PCB, ground connections 712 and 714 are also disposed symmetrically to either side of the imaginary plane. The distance between ground connection 712 and ground connection 714 need not be identical to the distance between ground connection 706 and ground connection 708, so long as each pair of ground connections is disposed symmetrically with respect to the imaginary plane, or with respect to a portion of the differential signal trace pair that forms a line segments within the imaginary plane.

FIG. 8 is an illustrative diagram of a second symmetrical arrangement of an odd number of ground connections disposed on different surfaces of a printed circuit board, in accordance with some implementations of the subject matter of this disclosure. FIG. 8 depicts two opposing surfaces 804 and 810 of a PCB. Signal source 800 and differential signal trace pair 802 are disposed on a first surface 804 of a PCB. Ground connections 806 and 808 are also disposed on first surface 804 and arranged symmetrically to either side of an imaginary plane perpendicular to surface 804 that includes differential signal trace pair 802 as a line segment within the imaginary plane. On the opposing surface 810 of the PCB, ground connections 812, 814, and 816 are also disposed symmetrically to either side of the imaginary plane, which is to say that the imaginary plane intersects ground connection 814 at its midpoint such that half of ground connection 814 is disposed to either side of the imaginary plane. Ground connections 812 and 816 are disposed at equidistant locations to either side of the imaginary plane. As with the example of FIG. 7, the distance between ground connection 812 and ground connection 816 need not be identical to the distance between ground connection 806 and ground connection 808, so long as each pair of ground connections is disposed symmetrically with respect to the imaginary plane, or with respect to a portion of the differential signal trace pair that forms a line segments within the imaginary plane.

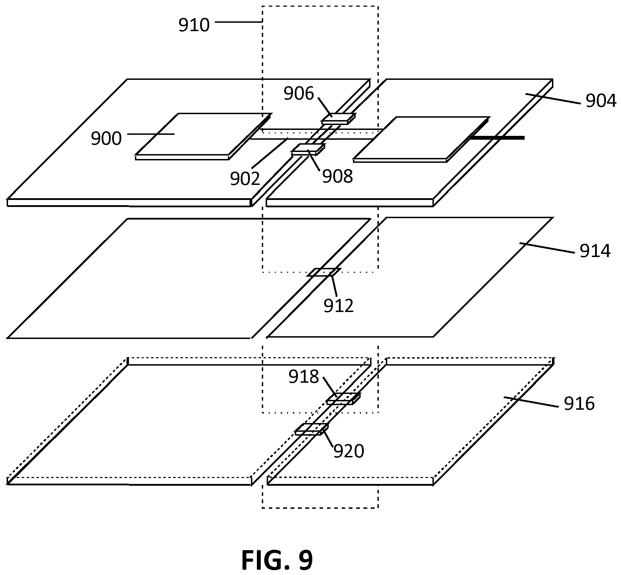

FIG. 9 is an illustrative diagram of a symmetrical arrangement of an odd number of ground connections disposed on different surfaces and within at least on interior layer of a printed circuit board, in accordance with some implementations of the subject matter of this disclosure. Signal source 900 and differential signal trace pair 902 are disposed on a first surface 904 of a PCB. Ground connections 906 and 908 are also disposed on first surface 904 and arranged symmetrically to either side of an imaginary plane 910 perpendicular to surface 904 that includes differential signal trace pair 902 as a line segment within the imaginary plane. Ground connection 912 is then disposed on an interior layer 914 of the PCB at a location such that imaginary plane 910 intersects ground connection 912 at its midpoint, with half of ground connection 912 is disposed to either side of the imaginary plane. On the opposing surface 916 of the PCB, ground connections 918 and 920 are also disposed symmetrically with respect to imaginary plane 910. The distance between ground connection 918 and ground connection 920 need not be identical to the distance between ground connection 906 and ground connection 908, so long as each pair of ground connections is disposed symmetrically with respect to imaginary plane 910.

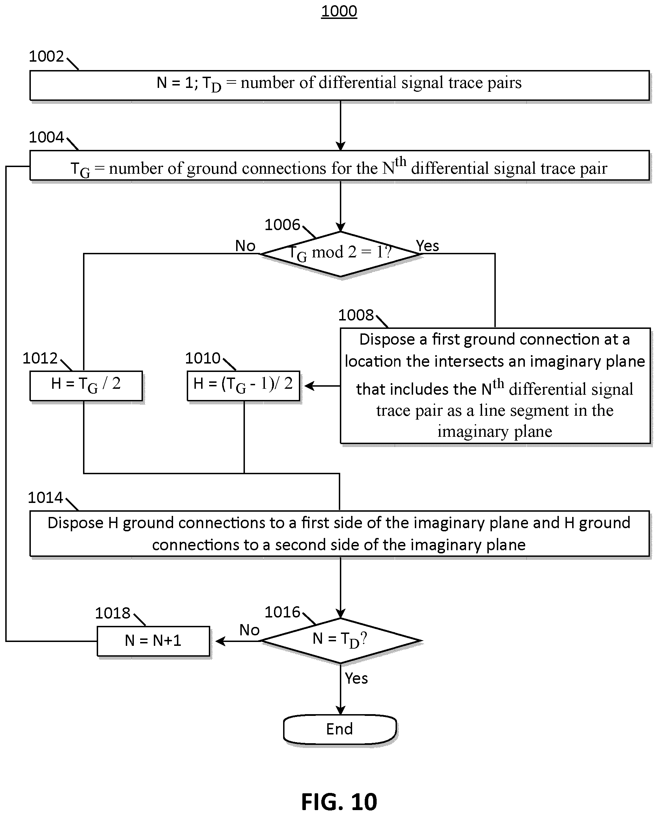

FIG. 10 is a flow diagram representing an illustrative process for shielding a differential signal trace pair using a symmetrical arrangement of ground connections, in accordance with some implementations of the subject matter of this disclosure. At 1002, a counter variable N is initialized with an initial value of 1. A variable T_{D} is also initialized, representing the number of differential signal trace pairs for which ground connections must be disposed in a respective symmetrical arrangement.

At 1004, a variable T_{G} is initialized, representing the number of ground connections to be disposed in a symmetrical arrangement around the N^{th} differential signal trace pair. At 1006, it is determined whether T_{G} is an odd number using, e.g., a modulus function to determine whether the remainder that results from dividing T_{G} by 2 is equal to 1.

If T_{G} is and odd number ("Yes") at 1006, then, at 1008, a first ground connection is disposed at a location that intersects an imaginary plane that includes the N^{th} differential signal trace pair as a line segment in the imaginary plane. Then, at 1010, the value of a variable H is set to half of the remaining number of ground connections (i.e., half of one less than T_{G}). If T_{G} is an even number ("No" at 1006), then, at 1012, the value of H is set to half of T_{G}.

At 1014, H ground connections are disposed to a first side of the imaginary plane. H ground connections are also disposed to a second side of the imaginary plane. Each pair of ground connections may be disposed on the same surface of a PCB as the N^{th} differential signal trace pair, or an opposing surface of the PCB.

At 1016, it is determined whether N is equal to T_{D}, meaning that ground connections have been disposed in a symmetrical arrangement for all differential signal trace pairs. If N is not equal to T_{D} ("No" at 1016), then, at 1018, the value of N is incremented by 1, and the process returns to 1004. If N is equal to T_{D} ("Yes" at 1016), then the process ends.

Thus it is seen that methods and systems for shielding differential signal trace pairs communicatively coupling one or more signal sources and one or more medium dependent interface ports in an automotive network have been provided.

As used herein and in the claims which follow, the construction "one of A and B" shall mean "A or B."

It is noted that the foregoing is only illustrative of the principles of the invention, and that the invention can be practiced by other than the described embodiments, which are presented for purposes of illustration and not of limitation, and the present invention is limited only by the claims which follow.

### The following is a list of further preferred embodiments of the invention:

Embodiment 1. A communication hub device in an automotive network, the communication hub device comprising:
   one or more ports, each port communicatively coupled to a signal source by a respective differential signal trace pair and having a medium dependent interface, wherein the differential signal trace pair is subject to electromagnetic interference or electrostatic discharge; and
   for each respective differential signal trace pair, a respective symmetrical arrangement of ground connections configured to shield the respective differential signal trace pair from the electromagnetic interference and electrostatic discharge.
Embodiment 2. The communication hub device of embodiment1, wherein each of the respective differential signal trace pairs is disposed on a first surface of a printed circuit board.
Embodiment 3. The communication hub device of embodiment2, wherein the respective symmetrical arrangement of ground connections comprises a solid ground plane disposed on a second surface of the printed circuit board.
Embodiment 4. The communication hub device of embodiment2, wherein the printed circuit board is a multi-layer printed circuit board, and wherein the respective symmetrical arrangement of ground connections comprises a solid ground plane disposed on an interior layer of the printed circuit board.
Embodiment 5. The communication hub device of embodiment1, wherein:
   each of the respective differential signal trace pairs is disposed on a first surface of a printed circuit board having a major plane, each respective differential signal trace pair being disposed within a respective imaginary second plane that includes the respective differential signal trace pair as a line segment in the respective imaginary second plane, the respective imaginary second plane being perpendicular to the major plane; and
   the respective symmetrical arrangement of ground connections comprises an even number of ground connections disposed on the first surface, a first half of the ground connections being disposed to a first side of the corresponding respective imaginary second plane and a second half of the ground connections being disposed to a second side of the corresponding respective imaginary second plane.
Embodiment 6. The communication hub device of embodiments, wherein a line drawn through centers of all the ground connections is perpendicular to the respective differential signal trace pair.
Embodiment 7. The communication hub device of embodiments, wherein the even number of ground connections comprises only two ground connections.
Embodiment 8. The communication hub device of embodiment1, wherein:
   each respective differential signal trace pair is disposed on a first surface of a printed circuit board having a major plane, each respective differential signal trace pair being disposed within a respective imaginary second plane that includes the respective differential signal trace pair as a line segment in the respective imaginary second plane, the respective imaginary second plane being perpendicular to the major plane; and
   the respective symmetrical arrangement of ground connections comprises an odd number of ground connections, wherein a subset of ground connections comprising an even number of ground connections is disposed on the first surface, wherein a first half of the even number of ground connections are disposed to a first side of a corresponding respective imaginary second plane and a second half of the even number of ground connections are disposed to a second side of the corresponding respective imaginary second plane, and a remaining number of ground connections are disposed on a second surface of the printed circuit board opposite the first surface, wherein a first ground connection of the remaining number of ground connections is disposed at a location on the second surface that intersects the corresponding respective imaginary second plane, and a remainder of the remaining number of ground connections is distributed symmetrically with respect to the corresponding respective imaginary second plane.
Embodiment 9. The communication hub device of embodiment1, wherein each ground connection comprises a metallic strip.
Embodiment 10. The communication hub device of embodiment1, wherein each ground connection comprises a zero-ohm resistor.
Embodiment 11. The communication hub device of embodiment1, wherein each ground connection comprises a capacitor.
Embodiment 12. The communication hub device of embodiment1, further comprising one or more additional ground connections configured to shield the differential signal trace pairs from transient noise.
Embodiment 13. The communication hub device of embodiment1, further comprising a second signal source, wherein at least one port of the one or more ports is communicatively coupled to the second signal source.
Embodiment 14. The communication hub device of embodiment1, wherein a first respective symmetrical arrangement of ground connections differs in configuration from a second respective symmetrical arrangement of ground connections.
Embodiment 15. The communication hub device of embodiment1, wherein each of the respective differential signal trace pairs is disposed on a first surface of a multi-layer printed circuit board (PCB), at least one ground connection of a respective symmetrical arrangement of ground connections is disposed on a second surface of the multi-layer printed circuit board opposite the first surface, and at least one ground connection of the respective symmetrical arrangement of ground connections is disposed on an interior layer of the multi-layer printed circuit board.
Embodiment 16. A method of shielding a differential signal trace pair communicatively coupling a signal source and a medium dependent interface port in an automotive network, the differential signal trace pair being disposed (a) on a first surface of a printed circuit board having a major plane, and (b) within an imaginary plane that (i) includes the differential signal trace pair as a line segment in the imaginary plane, and (ii) is perpendicular to the major plane, the method comprising:
   disposing, in a symmetrical arrangement around the differential signal trace pair, one or more ground connections.
Embodiment 17. The method of embodiment16, wherein the one or more ground connections comprises an even number of ground connections, and wherein disposing, in a symmetrical arrangement around the differential signal trace pair, one or more ground connections comprises:
   disposing, to a first side of the imaginary plane, a first half of the one or more ground connections; and
   disposing, to a second side of the imaginary plane, a second half of the one or more ground connections.
Embodiment 18. The method of embodiment16, wherein the one or more ground connections comprises an odd number of ground connections, and wherein disposing, in a symmetrical arrangement around the differential signal trace pair, one or more ground connections comprises:
   disposing, on the first surface, a first half of a subset of ground connections to a first side of the imaginary plane, the subset of ground connections comprising an even number of ground connections;
   disposing, on the first surface, a second half of the subset of ground connections to a second side of the plane;
   disposing, on a second surface of the printed circuit board opposite the first surface, a first ground connection of a remaining number of ground connections at a location on the second surface that intersects the imaginary plane; and
   disposing, on the second surface, a remainder of the remaining number of ground connections distributed symmetrically with respect to the imaginary plane.
Embodiment 19. The method of embodiment16, wherein the printed circuit board is a multi-layer printed circuit board, and wherein disposing, in a symmetrical arrangement around the differential signal trace pair, one or more ground connections comprises:
   disposing, in an interior layer of the multi-layer printed circuit board, a ground connection of the one or more ground connections at a location, on the interior layer, that intersects the imaginary plane.
Embodiment 20. The method of embodiment16, wherein the printed circuit board is a multi-layer printed circuit board, and wherein disposing, in a symmetrical arrangement around the differential signal trace pair, one or more ground connections comprises:
   disposing, in an interior layer of the multi-layer printed circuit board, an even number of ground connections of the one or more ground connections distributed symmetrically with respect to the imaginary plane.
Embodiment 21. The method of embodiment16, wherein the printed circuit board is a multi-layer printed circuit board, and wherein disposing, in a symmetrical arrangement around the differential signal trace pair, one or more ground connections comprises:
   disposing, in an interior layer of the multi-layer printed circuit board, a first ground connection of the one or more ground connections at a location on the interior layer that intersects the imaginary plane; and
   disposing, in the interior layer of the multi-layer printed circuit board, an even number of ground connections of the one or more ground connections distributed symmetrically with respect to the imaginary plane.
Embodiment 22. The method of embodiment16, wherein disposing, in a symmetrical arrangement around the differential signal trace pair, one or more ground connections comprises disposing a solid ground plane at a location that intersects the imaginary plane.
Embodiment 23. The method of embodiment16, wherein disposing, in a symmetrical arrangement around the differential signal trace pair, one or more ground connections comprises disposing one or more pairs of metallic strips distributed symmetrically with respect to the imaginary plane.
Embodiment 24. The method of embodiment16, wherein disposing, in a symmetrical arrangement around the differential signal trace pair, one or more ground connections comprises disposing one or more zero-ohm resistors distributed symmetrically with respect to the imaginary plane.
Embodiment 25. The method of embodiment16, wherein disposing, in a symmetrical arrangement around the differential signal trace pair, one or more ground connections comprises disposing one or more capacitors distributed symmetrically with respect to the imaginary plane.

## Claims

1. A communication hub device in an automotive network, the communication hub device comprising:
one or more ports, each port communicatively coupled to a signal source by a respective differential signal trace pair and having a medium dependent interface, wherein the differential signal trace pair is subject to electromagnetic interference or electrostatic discharge; and
for each respective differential signal trace pair, a respective symmetrical arrangement of ground connections configured to shield the respective differential signal trace pair from the electromagnetic interference and electrostatic discharge.

2. The communication hub device of claim 1, wherein each of the respective differential signal trace pairs is disposed on a first surface of a printed circuit board.

3. The communication hub device of claim 2, wherein the respective symmetrical arrangement of ground connections comprises a solid ground plane disposed on a second surface of the printed circuit board.

4. The communication hub device of claim 2, wherein the printed circuit board is a multi-layer printed circuit board, and wherein the respective symmetrical arrangement of ground connections comprises a solid ground plane disposed on an interior layer of the printed circuit board.

5. The communication hub device of one of claims 1 to 4, wherein:
each of the respective differential signal trace pairs is disposed on a first surface of a printed circuit board having a major plane, each respective differential signal trace pair being disposed within a respective imaginary second plane that includes the respective differential signal trace pair as a line segment in the respective imaginary second plane, the respective imaginary second plane being perpendicular to the major plane; and
the respective symmetrical arrangement of ground connections comprises an even number of ground connections disposed on the first surface, a first half of the ground connections being disposed to a first side of the corresponding respective imaginary second plane and a second half of the ground connections being disposed to a second side of the corresponding respective imaginary second plane.

6. The communication hub device of claim 5, wherein a line drawn through centers of all the ground connections is perpendicular to the respective differential signal trace pair, and/or
wherein the even number of ground connections comprises only two ground connections.

7. The communication hub device of one of claims 1 to 6, wherein:
each respective differential signal trace pair is disposed on a first surface of a printed circuit board having a major plane, each respective differential signal trace pair being disposed within a respective imaginary second plane that includes the respective differential signal trace pair as a line segment in the respective imaginary second plane, the respective imaginary second plane being perpendicular to the major plane; and
the respective symmetrical arrangement of ground connections comprises an odd number of ground connections, wherein a subset of ground connections comprising an even number of ground connections is disposed on the first surface, wherein a first half of the even number of ground connections are disposed to a first side of a corresponding respective imaginary second plane and a second half of the even number of ground connections are disposed to a second side of the corresponding respective imaginary second plane, and a remaining number of ground connections are disposed on a second surface of the printed circuit board opposite the first surface, wherein a first ground connection of the remaining number of ground connections is disposed at a location on the second surface that intersects the corresponding respective imaginary second plane, and
a remainder of the remaining number of ground connections is distributed symmetrically with respect to the corresponding respective imaginary second plane, or
wherein each ground connection comprises a metallic strip, or
wherein each ground connection comprises a zero-ohm resistor, or
wherein each ground connection comprises a capacitor.

8. The communication hub device of one of claims 1 to 7, further comprising one or more additional ground connections configured to shield the differential signal trace pairs from transient noise.

9. The communication hub device of one of claims 1 to 8, further comprising a second signal source, wherein at least one port of the one or more ports is communicatively coupled to the second signal source, or
wherein a first respective symmetrical arrangement of ground connections differs in configuration from a second respective symmetrical arrangement of ground connections.

10. The communication hub device of one of claims 1 to 9, wherein each of the respective differential signal trace pairs is disposed on a first surface of a multi-layer printed circuit board (PCB), at least one ground connection of a respective symmetrical arrangement of ground connections is disposed on a second surface of the multi-layer printed circuit board opposite the first surface, and at least one ground connection of the respective symmetrical arrangement of ground connections is disposed on an interior layer of the multi-layer printed circuit board.

11. A method of shielding a differential signal trace pair communicatively coupling a signal source and a medium dependent interface port in an automotive network, the differential signal trace pair being disposed (a) on a first surface of a printed circuit board having a major plane, and (b) within an imaginary plane that (i) includes the differential signal trace pair as a line segment in the imaginary plane, and (ii) is perpendicular to the major plane, the method comprising:
disposing, in a symmetrical arrangement around the differential signal trace pair, one or more ground connections.

12. The method of claim 11, wherein the one or more ground connections comprises an even number of ground connections, and wherein disposing, in a symmetrical arrangement around the differential signal trace pair, one or more ground connections comprises:
disposing, to a first side of the imaginary plane, a first half of the one or more ground connections; and
disposing, to a second side of the imaginary plane, a second half of the one or more ground connections.

13. The method of one of claims 11 or 12, wherein the one or more ground connections comprises an odd number of ground connections, and wherein disposing, in a symmetrical arrangement around the differential signal trace pair, one or more ground connections comprises:
disposing, on the first surface, a first half of a subset of ground connections to a first side of the imaginary plane, the subset of ground connections comprising an even number of ground connections;
disposing, on the first surface, a second half of the subset of ground connections to a second side of the plane;
disposing, on a second surface of the printed circuit board opposite the first surface, a first ground connection of a remaining number of ground connections at a location on the second surface that intersects the imaginary plane; and
disposing, on the second surface, a remainder of the remaining number of ground connections distributed symmetrically with respect to the imaginary plane.

14. The method of one of claims 11 to 13, wherein the printed circuit board is a multi-layer printed circuit board, and wherein disposing, in a symmetrical arrangement around the differential signal trace pair, one or more ground connections comprises:
disposing, in an interior layer of the multi-layer printed circuit board, a ground connection of the one or more ground connections at a location, on the interior layer, that intersects the imaginary plane, or
wherein the printed circuit board is a multi-layer printed circuit board, and wherein disposing, in a symmetrical arrangement around the differential signal trace pair, one or more ground connections comprises:
disposing, in an interior layer of the multi-layer printed circuit board, an even number of ground connections of the one or more ground connections distributed symmetrically with respect to the imaginary plane, or
wherein the printed circuit board is a multi-layer printed circuit board, and wherein disposing, in a symmetrical arrangement around the differential signal trace pair, one or more ground connections comprises:
disposing, in an interior layer of the multi-layer printed circuit board, a first ground connection of the one or more ground connections at a location on the interior layer that intersects the imaginary plane; and
disposing, in the interior layer of the multi-layer printed circuit board, an even number of ground connections of the one or more ground connections distributed symmetrically with respect to the imaginary plane.

15. The method of one of claims 11 to 14, wherein disposing, in a symmetrical arrangement around the differential signal trace pair, one or more ground connections comprises disposing a solid ground plane at a location that intersects the imaginary plane, or
wherein disposing, in a symmetrical arrangement around the differential signal trace pair, one or more ground connections comprises disposing one or more pairs of metallic strips distributed symmetrically with respect to the imaginary plane, or
wherein disposing, in a symmetrical arrangement around the differential signal trace pair, one or more ground connections comprises disposing one or more zero-ohm resistors distributed symmetrically with respect to the imaginary plane, or
wherein disposing, in a symmetrical arrangement around the differential signal trace pair, one or more ground connections comprises disposing one or more capacitors distributed symmetrically with respect to the imaginary plane.
